## Europäisches Patentamt
## European Patent Office
## Office européen des brevets

(11) Veröffentlichungsnummer: **0 252 399**
**A2**

# (12) EUROPÄISCHE PATENTANMELDUNG

(21) Anmeldenummer: 87109333.2

(51) Int. Cl.4: **H05K 3/18 , H05K 3/22**

(22) Anmeldetag: 29.06.87

(30) Priorität: 09.07.86 DE 3623505

(43) Veröffentlichungstag der Anmeldung:
13.01.88 Patentblatt 88/02

(84) Benannte Vertragsstaaten:
AT BE CH DE ES FR GB GR IT LI LU NL SE

(71) Anmelder: Deutsche Telephonwerke und Kabelindustrie Aktiengesellschaft
Wrangelstrasse 100
D-1000 Berlin 36(DE)

(72) Erfinder: De Boer, Reinhard
Birnhornweg 19
D-1000 Berlin 42(DE)

(54) Verfahren zum Herstellen von Leiterplatten mit Kupferoberflächen.

(57) Die Erfindung beschreibt ein Verfahren zum Herstellen von Leiterplatten mit Kupferoberflächen, bei dem nach dem Aufhellen und Trocknen der Blei-Zinn-Schicht eine Verfahrensstufe eingesetzt wird, bei der nur die Lötaugen der Leiterplatte beidseitig durch einen zweiten Fotodruck überspannt (getentet) werden, die galvanische Blei-Zinn-Schicht und der zweite Fotodruck-Lötstoppresist abgelöst werden, die Leiterplatte beidseitig mit einem Lötstopp-Fotofestresist versehen und anschließend konventionell umgeschmolzen wird.

EP 0 252 399 A2

## Verfahren zum Herstellen von Leiterplatten mit Kupferoberflächen

Die Erfindung bezieht sich auf ein Verfahren zum Herstellen von Leiterplatten mit Kupferoberflächen nach dem Oberbegriff des Patentanspruches 1.

Derartige Verfahren sind bekannt, z. B. aus der DE-OS 34 12 447, DE-PS 32 14 807 und EP 0 154 909. Bevorzugt wird dabei ein Heißluftverzinnen der Bohrlöcher und Lötaugen angewendet, das relativ aufwendig ist.

Außerdem können beim Aufschmelzen der Leiterbahnen bei diesen Verfahren Blei-Zinnbrücken auftreten.

Ferner ist bei den üblichen Verfahren der Heißluftverzinnung ein Unterkriechen des Blei-Zinnlotes unter den Lötstopp-Fotofestresist beim Löten möglich.

Der Erfindung liegt die Aufgabe zugrunde, die genannten Nachteile durch Abwandeln des herkömmlichen Herstellungsverfahrens zu beseitigen, wobei insbesondere das Heißluftverzinnen der Lötaugen vermieden werden soll.

Diese Aufgabe ist durch die Erfindung gelöst, wie sie im Kennzeichnungsteil des ersten Patentanspruches dargelegt ist.

Das Verfahren basiert auf der Verarbeitung von Fotoresisten mittels alkalisch-wässriger Lösungen, wie z. B. einer einprozentigen Sodalösung.

Durch die Erfindung entfällt das aufwendige Heißluftverzinnen der Lötaugen und es ergeben sich weitere Vorteile: die definierten Schichtstärken der Blei-Zinn-Abscheidungen gewährleisten optimale Löt-und Lagerverhältnisse. Diese definierten Blei-Zinnschichten sind u. a. für die Direktlötung von Bauelementen auf der Oberfläche von Leiterplatten erforderlich (sogenannte SMD-Technik). Weiterhin ist die Fertigung von Feinstleitern uneingeschränkt möglich, da keine Blei-Zinnlotbrücken beim Aufschmelzen auftreten können. Zudem ist eine weit größere Haftung von Lötstopp-Fotofestresisten und Flüssigresisten auf Kupfer-als auf Blei-Zinnoberflächen erzielbar. Dadurch kann beispielsweise kein Blei-Zinnlot beim Löten unter den Lötstopp-Fotoresist kriechen. Schließlich ist das Verfahren gegenüber der Heißverzinnungstechnik wesentlich wirtschaftlicher.

Das Verfahren zum Herstellen von Leiterplatten läuft zunächst in herkömmlichen, bekannten Schritten der Fotoresistmethode ab. So wird auf die Kupferoberfläche der Fotoresist laminiert, über eine Fotovorlage mit UV-Licht belichtet und danach alkalisch-wässrig entwickelt. Danach werden galvanisch die nicht durch das Fotoresist abgedeckten Teile mit Kupfer verstärkt und anschließend wird auf die Teile eine Blei-Zinn-Schicht ebenfalls galvanisch aufgebracht. Im nächsten Arbeitsschritt wird die Fotoresistschicht von der Leiterplatte abgelöst. Durch ein Ätzbad wird sodann das freigelegte Kupfer entfernt. Die Blei-Zinn-Schicht der Leiterplatte wird danach aufgehellt und getrocknet als Vorbereitung der Oberfläche für den späteren Aufschmelzvorgang.

Abweichend von den bisher bekannten Verfahren wird erfindungsgemäß ein zweiter Fotodruck vorgenommen, indem wiederum die Leiterplatte mit einem Fotoresist beidseitig laminiert wird. Anschließend werden nur die Lötaugen belichtet und danach der Fotoresist entwickelt. Das folgende Strippen löst die nicht abgedeckten Blei-Zinn-Schichten ab. Dieses Strippen und das anschließende Spülen wird ausschließlich durch Sprühen vorgenommen.

Danach wird durch alkalisches Strippen, durch Sprühen und/oder Tauchen, der Fotoresist gelöst.

Ein weiterer Spülgang dient der Oberflächenreinigung vor dem Desoxidieren des freigelegten Kupfers. Nach dem Desoxidieren wird erneut die Oberfläche gespült. Ein Trocknen beschließt die Verfahrensstufe.

Die weiteren Schritte zur Herstellung von Leiterplatten sind die bekannten Verfahrensstufen konventioneller Art mittels Lötstopp-Fotofestresisten oder Flüssigresisten und dem Aufschmelzen der Lotschicht.

## Ansprüche

1) Verfahren zum Herstellen von Leiterplatten mit Kupferoberflächen, wobei mittels Fotovorlagen, UV-lichtempfindlichen Fotoresisten und durch alkalisches Entwickeln die Leiterzüge erstellt werden und anschließend Kupfer-und Blei-Zinn-Schichten galvanisch darauf abgeschieden werden, dadurch gekennzeichnet, daß nach dem Strippen, Ätzen, Aufhellen und dem Trocknen der Leiterplatte die folgenden Verfahrensschritte ausgeführt werden:

a) Aufbringen einer zweiten Fotoresistschicht,

b) Belichten der Lötaugen mit einer Fotovorlage,

c) Entwickeln des Fotoresists,

d) Strippen der Blei-Zinn-Schicht,

e) alkalisch-wässriges Strippen des Fotoresists,

f) Desoxidieren und

g) Trocknen.

2) Verfahren nach Anspruch 1, dadurch gekennzeichnet, daß die zweite Fotoresistschicht beidseitig auf die Leiterplatte aufgebracht wird.

3) Verfahren nach Anspruch 1, dadurch gekennzeichnet, daß das Strippen nach dem Verfahrensschritt d) durch Besprühen der Leiterplatten vorgenommen wird.

4) Verfahren nach Anspruch 1, dadurch gekennzeichnet, daß nach jedem Verfahrensschritt, beginnend mit dem Schritt c) ein Spülen der Leiterplattenoberflächen durch Sprühen und/oder Tauchen vorgenommen wird.

5) Verfahren nach Anspruch 1 und 4, dadurch gekennzeichnet, daß nach dem Abschluß der Verfahrensstufe, bestehend aus den Verfahrensschritten a) bis f), und dem anschließenden Spülen die Leiterplattenoberflächen getrocknet werden, danach in herkömmlicher Art mit einem Lötstopp-Fotoresist versehen und die Blein-Zinn-Schichten aufgeschmolzen werden.